# EUROPÄISCHE PATENTSCHRIFT

(11) **EP 2 350 636 B1**
(45) Veröffentlichungstag und Bekanntmachung des Hinweises auf die Patenterteilung: **05.09.2012**
(21) Anmeldenummer: 09805992.6
(22) Anmeldetag: 18.11.2009
(51) Int. Cl.: G01N 27/87, B21B 38/00

(54) **VERFAHREN ZUR AUTOMATISIERTEN MESSUNG DER MAGNETISCHEN RESTFELDSTÄRKE VON AUFMAGNETISIERTEN FERROMAGNETISCHEN WERKSTÜCKEN**
METHOD FOR THE AUTOMATED MEASURING OF THE RESIDUAL MAGNETIC FIELD STRENGTH OF MAGNETIZED FERROMAGNETIC WORKPIECES
PROCÉDÉ DE MESURE AUTOMATISÉE DE L'INTENSITÉ DU CHAMP MAGNÉTIQUE RÉSIDUEL DE PIÈCES FERROMAGNÉTIQUES MAGNÉTISÉES

(30) Priorität: 27.11.2008 DE 102008059663
(43) Veröffentlichungstag der Anmeldung: 03.08.2011
(73) Patentinhaber: V & M Deutschland GmbH, 40472 Düsseldorf (DE)
(72) Erfinder: KAACK, Michael, 44801 Bochum (DE); NITSCHE, Stefan, 45475 Mülheim (DE); GERMES, André, 40472 Düsseldorf (DE)
(74) Vertreter: Meissner, Peter E.
(86) Internationale Anmeldenummer: PCT/DE2009/001657
(87) Internationale Veröffentlichungsnummer: WO 2010/060415

(56) Entgegenhaltungen:
- DE-A1- 2 238 012
- DE-A1-102004 035 174
- GB-A- 2 197 958
- FARMAN M ET AL: "The origin and influence of residual magnetism on the electron beam welding of 18% Ni-maraging steels" MATERIALS AND DESIGN, LONDON, GB LNKD- DOI:10.1016/0261-3069(88)90003-9, Bd. 9, Nr. 5, 1. September 1988 (1988-09-01), Seiten 263-271, XP024152744 ISSN: 0261-3069 [gefunden am 1988-09-01]

## Beschreibung

Die Erfindung betrifft ein Verfahren zur automatisierten Messung der Restfeldstärke von aufmagnetisierten ferromagnetischen Werkstücken, insbesondere von Rohren aus Stahl, gemäß dem Oberbegriff des Patentanspruches 1.

Die Fehlerprüfung von Stahlrohren wird oft mit Hilfe magnetischer Verfahren oder mit magnetinduktiven Verfahren unter Verwendung einer Vormagnetisierung durchgeführt. Dabei sind anschließend magnetische Restfelder im Prüfling vorhanden, deren Stärke und Richtung abhängig sind von der genauen Ausführung der Prüfung und den Werkstoffeigenschaften. Ungewollte Aufmagnetisierungen können jedoch auch bei der Rohrherstellung, bei der Weiterverarbeitung und beim Transport der Rohre entstehen.

Magnetische Restfelder können für die Weiterverarbeitung beim Kunden störend sein und sollten daher entsprechend gering gehalten werden.

Insbesondere im Bereich der Rohrenden sind diese magnetischen Restfelder sehr störend, weil der beim Aneinanderschweißen der Rohre entstehende Lichtbogen von diesen magnetischen Restfeldern ungünstig beeinträchtigt wird. Bei zu starken Restfeldern an der Stirnfläche der Rohrenden kommt es zu Ablenkungen des Lichtbogens, so dass ein Verschweißen erschwert oder sogar unmöglich wird.

Aus vorgenanntem Grund gibt es Kundenanforderungen die eine Entmagnetisierung eigentlich noch tolerierbarer magnetischer Restfeldstärken an den Rohrenden notwendig machen.

Um den Erfolg des Absenkens der magnetischen Restfelder unter einen vorgegebenen Wert kontrollieren zu können, ist eine Messung der magnetischen Restfelder am Rohr notwendig.

Üblicherweise werden in der Praxis dazu die magnetischen Restfelder mit Handmessgeräten, wie z. B. Hallsonden, an der Stirnfläche des Rohres gemessen. Grundsätzlich ist die Verwendung von Geräten zur Messung von Magnetfeldern (Gaußmeter) beispielsweise aus der OS 2 238 012 bekannt und zur Bestimmung von magnetischen Restfeldern an Rohren durchaus üblich. Zur Messung des Restfeldes wird dazu eine kalibrierte Hallsonde auf die Stirnfläche des Rohrendes aufgesetzt.

Nachteil dieses Messverfahrens ist, dass die Messung an der Stirnfläche aus konstruktiven Gründen nur schwer mit vertretbarem Kostenaufwand automatisiert werden kann.

Teilweise werden freistehende Magnetfeldsonden zur automatischen Messung von vorbei bewegten Rohren verwendet. Diese Messungen sind jedoch nicht sehr aussagekräftig, weil dafür eine kontaktierende Messung der Rohre notwendig wäre, die aber wegen des hohen Risikos der Beschädigung durch das vorbei laufende Rohr unterbleibt.

Zudem ist die Realisierung eines genau definierten Abstandes zur Stirnfläche des Rohres bei bewegten Rohren nur schwer möglich. Variationen der Signale können daher nicht eindeutig Änderungen der Restfeldstärke zugeordnet werden, denn Ursache könnte auch eine ungewollte Änderung des Abstandes der Sonde zur Stirnfläche des Rohres sein. Die Signalstärke nimmt mit zunehmendem Abstand deutlich ab, wodurch die Auswertbarkeit der Messergebnisse stark erschwert wird.

Aus der GB 2 197 958 A ist die Messung der Restmagnetisierung von zylindrischen,geologischen Proben bekannt, wobei die Proben hierzu an einer Messsonde vorbeigeführt werden, so dass die Restmagnetisierung entlang der Oberfläche gemessen werden kann.

Aufgabe der Erfindung ist es, ein Verfahren zur automatisierten Messung der Restfeldstärke von aufmagnetisierten ferromagnetischen Werkstücken, insbesondere von Rohren aus Stahl, anzugeben, mit dem eine stirnseitig am Rohrende vorhandene Restfeldstärke kostengünstig, schnell, einfach und reproduzierbar ermittelt werden kann.

Diese Aufgabe wird nach dem Oberbegriff in Verbindung mit den kennzeichnenden Merkmalen des Anspruches 1 gelöst. Vorteilhafte Weiterbildungen sind Gegenstand von Unteransprüchen.

Nach der Lehre der Erfindung wird anstelle einer direkten stirnseitigen Messung der Restfeldstärke der Verlauf mindestens einer Magnetfeldkomponente an der außenseitigen Oberfläche des Rohres mindestens im Bereich der Rohrenden und über die Rohrenden hinaus gemessen und auf Basis vorher ermittelter Korrelationen zwischen der stirnseitig und an der Rohroberfläche gemessenen Restfeldstärke auf die stirnseitig vorhandene Restfeldstärke geschlossen.

Das Verfahren besteht darin, dass zunächst tatsächlich eine Messung stirnseitig und an der Rohroberfläche erfolgt und darauf rechnerisch eine Korrelation abgeleitet wird, wobei dies vorher an Proberohren geschieht.
Diese rechnerisch ermittelte Korrelation wird dann bei der eigentlichen Prüfung der Rohre aus der Produktion angewandt, so dass ohne Messung an der Stirnseite aus der Messung an der Rohroberfläche auf die Restfeldstärke an der Stirnseite geschlossen werden kann.

Auf Basis dieser Messwerte kann dann z. B. über vorher ermittelte und in einem Rechnersystem hinterlegte Korrelationskurven auf die stirnseitig am Rohr vorhandene Restfeldstärke umgerechnet werden.

Der Vorteil des vorgeschlagenen Verfahrens liegt darin, dass auf sehr kostengünstige und einfache Weise die Restfeldstärke an der Oberfläche des Rohres automatisiert gemessen werden kann und es zudem konstruktiv sehr einfach zu realisieren ist, da die Messungen problemlos während des Rohrtransportes z. B. über stationär oberhalb der Rohroberfläche angeordnete Messsonden durchgeführt werden können.

Mögliche Beschädigungen der Messsonden während des Rohrtransports werden durch die Einstellung eines definierten Abstandes zur Rohroberfläche sicher vermieden.

Aufgrund des vorab definiert eingestellten Abstandes zur Rohroberfläche, sind die Ergebnisse reproduzierbar und damit von hoher Aussagekraft. Eine präzise Führung der Sonden auch vor und hinter dem Rohr sollte auf jeden Fall gewährleistet werden.

Für die Auswertung der Feldstärkesignale hat sich als notwendig herausgestellt, die Messungen über das Rohrende hinaus durchzuführen, da die Signale dort charakteristischen Änderungen unterliegen, die für die Auswertung hervorragend genutzt werden können.

In einer vorteilhaften Weiterbildung der Erfindung beschränkt sich zur weiteren Steigerung der Aussagegenauigkeit die Messung und Auswertung nicht nur auf eine Magnetfeldkomponente, sondern es werden zwei Komponenten, insbesondere die radiale und axiale Komponente, herangezogen.

Die Messung geschieht in diesem Fall mit zwei separaten Messsonden. Es ist zwar grundsätzlich auch möglich, die Umfangskomponente der Feldstärke des magnetischen Feldes auszuwerten, es hat sich aber gezeigt, das diese im Gegensatz zur radialen und axialen Komponente zu geringe auswertbare Signalcharakteristika besitzt.

Für die Auswertung der Signale hat es sich als günstig erwiesen, den zeitlichen Verlauf des jeweiligen Wertemaximums und falls erforderlich zusätzlich den charakteristischen Kurvenverlauf der Messwerte als Ganzes zur Auswertung heranzuziehen.

Sollte während der Messung mit zusätzlich einwirkenden äußeren Feldern, z. B. von einer vorhandenen Entmagnetisierungsspule, gerechnet werden, so können diese Einflüsse vorteilhaft mit Hilfe einer geeigneten Abschirmung und mit analogen oder digitalen Filtern im Signalpfad ausgeschlossen werden.

Wenngleich das erfindungsgemäße Verfahren, insbesondere zur automatisierten Messung der Restfeldstärke an Rohrenden, entwickelt wurde, ist es jedoch grundsätzlich auch für jede andere Art von ferromagnetischen Werkstücken geeignet, bei denen ähnliche Probleme bei der stirnseitigen Messung vorhanden sind, wie z. B. bei Blechen.

Weitere Merkmale, Vorteile und Einzelheiten der Erfindung ergeben sich aus der nachfolgenden Beschreibung der dargestellten Figuren.

Es zeigen:
**Figur 1** eine schematische Darstellung einer Ausführungsform des erfindungsgemäßen Messverfahrens zur Messung der magnetischen Restfeldstärke an der Rohroberfläche,
**Figur 2** einen Messschrieb der verschiedenen Komponenten der magnetischen Restfeldstärke.

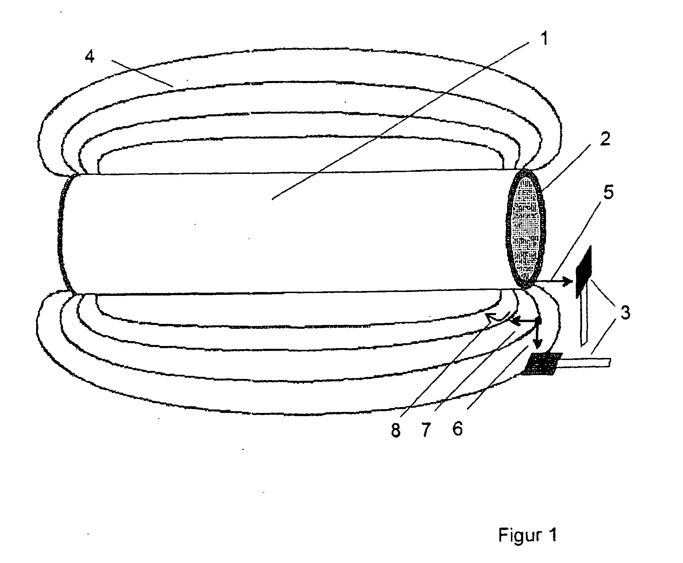

**Figur 1** zeigt in einer schematischen Darstellung eine Ausführungsform des erfindungsgemäßen Messverfahrens zur Messung der magnetischen Restfeldstärke an der Rohroberfläche.

Ein Rohr 1 weist ein magnetisches Restfeld 4 auf, welches u. a. an der Stirnfläche 2 des Rohres 1 als axial gerichtetes Magnetfeld 5 austritt und dort mittels einer entsprechenden Messsonde 3 nach dem Stand der Technik im Normalfall nur manuell gemessen werden kann.

Da die stirnseitige Messung während des Rohrtransports automatisiert nur schwer und nicht exakt durchgeführt werden kann, wird die Messung erfindungsgemäß jetzt an der Rohraußenobertläche durchgeführt.

Hierzu ist die Messsonde 3 in einem definierten Abstand von der Außenoberfläche des Rohres 1 fest positioniert angeordnet, so dass die magnetische Restfeldstärke des Rohres 1 auch während des Transportes, z. B. über einen Rollgang, auf einfache Weise automatisiert über die gesamte Rohrlänge erfolgen kann.

**Figur 1** zeigt auch, dass die magnetischen Feldlinien des magnetisches Restfeldes 4 nicht nur in axialer Richtung an der Stirnfläche des Rohres austreten, sondern davon ausgehend sich bogenförmig bis zum anderen Ende erstrecken. Die in radiale 6, axiale 7 und in Umfangskomponente 8 aufteilbaren Magnetfeldlinien werden erfindungsgemäß in einem Abstand von der Rohraußenoberfläche separat erfasst und ausgewertet.

Über Korrelationsmessungen zwischen der stirnseitig gemessenen Restfeldstärke und den an der Außenoberfläche des Rohres 1 ermittelten Feldstärken der einzelnen Komponenten, kann anschließend auf die stirnseitig vorliegende Restfeldstärke geschlossen werden.

Auf Basis der gemessenen Restfeldstärken kann dann auf einfache Weise, z. B. über vorher ermittelte und in einem Rechnersystem hinterlegte Korrelationskurven, auf die stirnseitig am Rohr vorhandene Restfeldstärke umgerechnet werden.

Vorteilhaft werden dafür für verschiedene Rohrdurchmesser und Werkstoffe vorab Messungen durchgeführt und die Werte in einer Datenbank gespeichert.

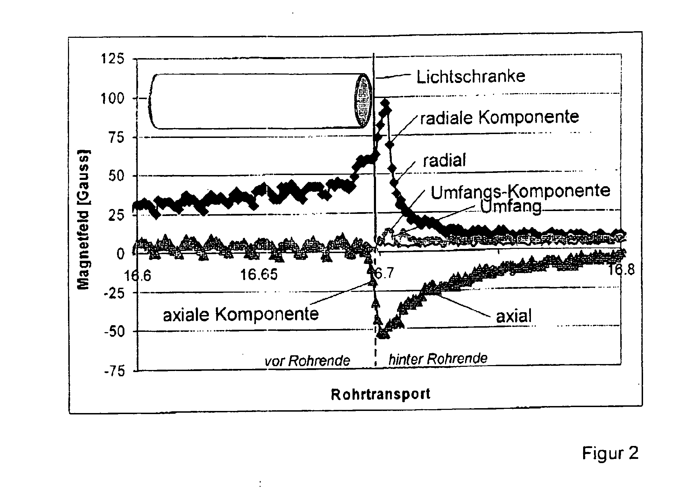

In **Figur 2** ist ein Messschrieb für den Signalverlauf der verschiedenen Komponenten der magnetischen Restfeldstärke dargestellt. Hier ist zu sehen, dass wesentliche Beiträge zu den Magnetfeldern an der Außenoberfläche des Rohres erst hinter dem Lichtschrankensignal, d. h. hinter dem Rohrende bzw. vor dem Rohranfang, zu finden sind. Daher ist eine präzise Führung der Sonden auch hier sicherzustellen.

In den Messkurven zeigen sich bestimmte Charakteristika, insbesondere eine Stufe am Ende des Rohres in der radialen und in der axialen Komponente, die zur Auswertung herangezogen werden können. Die Umfangskomponente der magnetischen Feldstärke hingegen weist keine auswertbaren Merkmale auf und bleibt deshalb unberücksichtigt.

### Bezugszeichenliste

| **Nr.** | **Bezeichnung** |
|---|---|
| 1 | Rohr |
| 2 | Stirnfläche |
| 3 | Messsonde |
| 4 | Magnetfeldlinien |
| 5 | Magnetfeld an der Stirnseite |
| 6 | radiale Magnetfeldkomponente |
| 7 | axiale Magnetfeldkomponente |
| 8 | Magnetfeldkomponente in Umfangsrichtung |

## Patentansprüche

1. Verfahren zur automatisierten Messung der Restfeldstärke von aufmagnetisierten ferromagnetischen Rohren aus Stahl, wobei mit einer Messsonde (3) das stirnseitig am Rohrende (2) austretende magnetische Restfeld bestimmt wird,
**dadurch gekennzeichnet,**
**dass** der Verlauf mindestens einer Magnetfeldkomponente (6,7,8) an der außenseitigen Oberfläche des Rohres (1) mindestens im Bereich der Rohrenden und über die Rohrenden hinaus gemessen wird und auf Basis vorher ermittelter Korrelationen zwischen der stirnseitig gemessenen und an der Rohroberfläche gemessenen Restfeldstärke auf die stirnseitig vorhandene Restfeldstärke geschlossen wird.

2. Verfahren nach Anspruch 1
**dadurch gekennzeichnet,**
**dass** zwei Magnetfeldkomponenten ausgewertet werden.

3. Verfahren nach Anspruch 2
**dadurch gekennzeichnet,**
**dass** die Magnetfeldkomponenten (6,7) in radialer und axialer Richtung des Rohres ausgewertet werden.

4. Verfahren nach einem der Ansprüche 1 - 3
**dadurch gekennzeichnet,**
**dass** zur Auswertung der zeitliche Verlauf des jeweiligen Wertemaximums herangezogen wird.

5. Verfahren nach Anspruch 4
**dadurch gekennzeichnet,**
**dass** zusätzlich der charakteristische Kurvenverlauf der Messwerte als Ganzes zur Auswertung herangezogen wird.

## Claims

1. A method for the automated measurement of the residual field strength of magnetized ferromagnetic pipes of steel, wherein the magnetic residual field emerging at the end face of the pipe end (2) is determined by means of a measuring probe (3), **characterised in that** the variation of at least one magnetic field component (6, 7, 8) is measured at the exterior surface of the pipe (1) at least in the region of the pipe ends and beyond the pipe ends and the residual field strength present at the end face is deduced on the basis of previously ascertained correlations between the residual field strength measured at the end face and measured at the pipe surface.

2. A method according to claim 1, **characterised in that** two magnetic field components are evaluated.

3. A method according to claim 2, **characterised in that** the magnetic field components (6, 7) are evaluated in a radial and axial direction of the pipe.

4. A method according to any one of claims 1 - 3, **characterised in that** the variation with time of the respective value maximum is used for evaluation.

5. A method according to claim 4, **characterised in that** in addition the characteristic curve variation of the measured values as a whole is used for evaluation.

## Revendications

1. Procédé de mesure automatisée de l'intensité de champ résiduelle de tubes ferromagnétiques aimantés en acier, dans lequel le champ magnétique résiduel apparaissant côté frontal à l'extrémité de tube (2) est déterminé avec une sonde de mesure (3),
**caractérisé en ce que**
l'évolution d'au moins une composante de champ magnétique (6,7,8) sur la surface externe du tube (1) est mesurée au moins dans la zone des extrémités de tube et au-delà des extrémités de tube et fait ressortir l'intensité de champ résiduelle existant côté frontal sur la base de corrélations établies précédemment entre l'intensité de champ résiduelle mesurée côté frontal et l'intensité de champ résiduelle mesurée à la surface du tube.

2. Procédé selon la revendication 1,
**caractérisé en ce que**
deux composantes de champ magnétique sont exploitées.

3. Procédé selon la revendication 2,
**caractérisé en ce que**
les composantes de champ magnétique (6,7) sont exploitées dans les directions radiale et axiale du tube.

4. Procédé selon l'une quelconque des revendications 1 à 3,
**caractérisé en ce que**,
à des fins d'exploitation, on se sert de l'évolution en fonction du temps du maximum de valeur respectif.

5. Procédé selon la revendication 4,
**caractérisé en ce que**,
en complément, on se sert de l'évolution de courbe caractéristique des valeurs de mesure dans l'ensemble à des fins d'exploitation.
